# EUROPEAN PATENT APPLICATION

(11) **EP 4 734 685 A2**
(43) Date of publication of application: **29.04.2026**
(21) Application number: 25203035.8
(22) Date of filing: 18.09.2025
(51) Int. Cl.: H05K 7/20, H01H 9/52

(54) **SYSTEMS AND METHODS FOR THERMAL MANAGEMENT OF ELECTRICAL SWITCHES**

(30) Priority: 03.10.2024 US 202418905908
(71) Applicant: Microsoft Technology Licensing, LLC, Redmond, WA 98052 (US)
(72) Inventor: NASR AZADANI, EHSAN, Redmond, 98052 (US); RAMAKRISHNAN, BHARATH, Redmond, 98052 (US); KEEHN, NICHOLAS ANDREW, Redmond, 98052 (US); TEWARI, SHUBHANGI, Redmond, 98052 (US)
(74) Representative: CMS Cameron McKenna Nabarro Olswang LLP

(57) **Abstract**

A system may include an electrical switch. A system may include a heat exchanger in thermal communication with the electrical switch and configured to receive heat from the electrical switch. A system may include a liquid cooling conduit configured to flow a working fluid therethrough, wherein the liquid cooling conduit is in thermal communication with the heat exchanger and configured to receive heat from the heat exchanger. A system may include an exhaust device in fluid communication with the liquid cooling conduit and configured to exhaust heat from the working fluid.

## Description

### BACKGROUND

Datacenters require a robust electrical power system to meet the power demands of highly variable computational loads. The controlling electrical switches can generate heat while distributing electrical current to co-locations and other electronic devices in the datacenter.

### BRIEF SUMMARY

In some aspects, the techniques described herein relate to a system for electrical power management, the system including: an electrical switch; a heat exchanger in thermal communication with the electrical switch and configured to receive heat from the electrical switch; a liquid cooling conduit configured to flow a working fluid therethrough, wherein the liquid cooling conduit is in thermal communication with the heat exchanger and configured to receive heat from the heat exchanger; and an exhaust device in fluid communication with the liquid cooling conduit and configured to exhaust heat from the working fluid.

In some aspects, the techniques described herein relate to a method of thermal management in a datacenter, the method including: flowing a cold working fluid toward a datacenter compute resource; receiving heat from the datacenter compute resource with the cold working fluid to create a warm working fluid; flowing the warm working fluid away from the datacenter compute resource toward an electrical switch of the datacenter; receiving heat from the electrical switch with the warm working fluid to create a hot working fluid; and exhausting heat from the hot working fluid.

In some aspects, the techniques described herein relate to a method of thermal management in a datacenter, the method including: flowing a first portion of a cold working fluid toward a datacenter compute resource; receiving heat from the datacenter compute resource with the first portion of the cold working fluid to create a first warm working fluid; flowing the first warm working fluid away from the datacenter compute resource toward a coolant distribution unit (CDU); flowing a second portion of a cold working fluid toward an electrical switch; receiving heat from the datacenter compute resource with the second portion of the cold working fluid to create a second warm working fluid; flowing the second warm working fluid away from the electrical switch toward the CDU; and exhausting heat from the warm working fluids.

This Summary is provided to introduce a selection of concepts in a simplified form that are further described below in the Detailed Description. This Summary is not intended to identify key features or essential features of the claimed subject matter.
Additional features and advantages will be set forth in the description which follows, and in part will be obvious from the description, or may be learned by the practice of the teachings herein. Features and advantages of the disclosure may be realized and obtained by means of the instruments and combinations particularly pointed out in the appended claims. Features of the present disclosure will become more fully apparent from the following description and appended claims or may be learned by the practice of the disclosure as set forth hereinafter.

### BRIEF DESCRIPTION OF THE DRAWINGS

In order to describe the manner in which the above-recited and other features of the disclosure can be obtained, a more particular description will be rendered by reference to specific embodiments thereof which are illustrated in the appended drawings. For better understanding, the like elements have been designated by like reference numbers throughout the various accompanying figures. While some of the drawings may be schematic or exaggerated representations of concepts, at least some of the drawings may be drawn to scale. Understanding that the drawings depict some example embodiments, the embodiments will be described and explained with additional specificity and detail through the use of the accompanying drawings in which:
FIG. 1 is a system diagram of a conventional system for providing and managing electrical power in a datacenter.
FIG. 2 is a schematic diagram of a datacenter power system, according to at least some embodiments of the present disclosure.
FIG. 3 is a schematic representation of a thermal management system for use in a datacenter power system, according to at least some embodiments of the present disclosure.
FIG. 4 is a schematic illustration of an embodiment of a thermal management system including a plurality of cooling loops, according to at least some embodiments of the present disclosure.
FIG. 5 is a schematic illustration of an embodiment of a thermal management system with a power electronics board and one or more co-locations in parallel, according to at least some embodiments of the present disclosure.
FIG. 6 is a flowchart of an embodiment of a method of thermal management in parallel cooling loops, according to at least some embodiments of the present disclosure.
FIG. 7 is a schematic illustration of an embodiment of a thermal management system with a power electronics board and one or more co-locations in fluidic series, according to at least some embodiments of the present disclosure.
FIG. 8 is a schematic illustration of an embodiment of a thermal management system with a power electronics board and one or more co-locations in series with a storage tank, according to at least some embodiments of the present disclosure.
FIG. 9 is a flowchart of an embodiment of another method of thermal management of a serial thermal management system, according to at least some embodiments of the present disclosure.
FIG. 10 is a side cross-sectional view of an embodiment of an IGBT with a cold plate, according to at least some embodiments of the present disclosure.
FIG. 11 is a side cross-sectional view of an IGBT with integrated liquid-based cooling in the base plate, according to at least some embodiments of the present disclosure.
FIG. 12 is a perspective view of a power electronics board and electrical switches immersion cooled, according to at least some embodiments of the present disclosure.

### DETAILED DESCRIPTION

The present disclosure generally relates to systems and methods for providing electrical power to a datacenter. In some embodiments, a datacenter power system according to the present disclosure provides more stable and/or higher power delivery from a utility grid to server computers and other electrical devices in a datacenter. More particularly, a datacenter power system, in some embodiments, includes a liquid-cooled electrical switch to manage heat generated during electrical power delivery to portions of the datacenter. For example, the datacenter power system may include any power conversion from AC/DC, AC/AC, and DC/DC which may include a liquid-cooled power electronic device such as an electrical switch including a power metal-oxide semiconductor field effect transistor (MOSFET), bipolar junction transistor (BJT), and/or an insulated gate bipolar transistor (IGBT) switch.

In some examples, an electrical switch generates heat while electrical current flows therethrough. At least a portion of the electrical power in the current is dissipated as heat into the switch. In some examples, a higher amperage current generates a greater amount of heat in the switch. As datacenters increase in capacity and demand, the amperage of the electrical power to co-locations, compute resources, network modules, storage device, power distribution units (PDUs), heating, ventilation, and air conditioning (HVAC) systems, and other portions of datacenters may increase. In some embodiments, thermal management of an electrical switch in or for a datacenter allows for greater electrical power to be delivered to portions of the datacenter and overall computational capacity of the datacenter to increase.

In some embodiments, thermal management of an electrical switch in or for a datacenter allows for a smaller footprint of the datacenter and/or greater flexibility in datacenter design and location. For example, air cooling of heat-generating components of a datacenter can limit the datacenter design and/or location. Air cooling of the heat-generating components can require comparatively large ducting in the datacenter structure relative to a liquid conduit to move heat from the electrical switch or other heat-generating components to an exhaust device. In some examples, air cooling of the heat-generating components needs relatively large air handling units (AHU) to cool the interior air of the datacenter. In some embodiments, systems and methods according to the present disclosure exhaust heat from the electrical switches to a working fluid without substantially heating the interior air. In some examples, air cooling of the heat-generating components requires ducting access to exhaust hot air to ambient atmosphere outside of the datacenter. In some embodiments, systems and methods according to the present disclosure transfer heat to an exhaust device by a working fluid.

In some embodiments, a thermal management system including liquid-cooling of electrical switches allows more design flexibility for edge-of-cloud (EOC) datacenters and other datacenters with small footprints and/or datacenters located closer to developed areas. For example, on undeveloped land, a datacenter can utilize air cooling or utilize the large-volume ducting for air cooling of the heat-generating components. In smaller footprint datacenters, such as EOC datacenters, the installation of compute resources and other heat-generating components may be restricted to smaller buildings, existing buildings lacking HVAC capacity for a datacenter, and/or portions of buildings without access to atmosphere exhaust (e.g., basements. Liquid cooling of electrical switches can allow more efficient and/or greater capacity heat transfer from the datacenter to atmosphere or other exhausts.

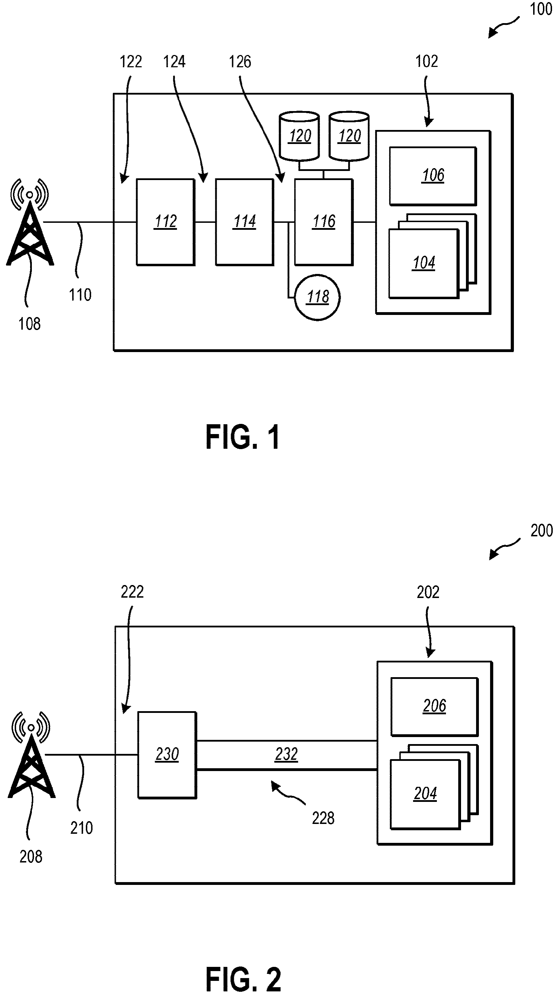

In some embodiments, datacenters include a plurality of power transformation or conversion systems that each require electrical power controls, such as switches. FIG. 1 is a system diagram of a conventional system for providing and managing electrical power in a datacenter. The datacenter power system 100 provides electrical power to, among other portions of the datacenter, one or more co-locations 102. The co-locations 102 include a plurality of computing devices 104. In some examples, the co-location 102 includes a power supply unit (PSU) 106 that receives, converts, and distributes electrical power to the computing devices 104.

The datacenter power system 100, in some examples, receives grid electrical power from a regional utility grid 108. The regional utility grid 108 provides the grid electrical power at a higher voltage than the co-location 102 can utilize, and the datacenter power system 100 converts the grid electrical power for use in the co-locations 102 of the datacenter. For example, the datacenter power system 100 receives the grid electrical power through a grid connection 110 to a high voltage transformer 112 that steps the voltage down. In some examples, the datacenter power system 100 then includes a middle voltage transformer 114 and a low voltage transformer 114 to further step the voltage down in stages and the amperage of the electrical current increases with each step down of voltage. The electrical conduits and the datacenter power system 100, as a whole, must compensate for the increased amperage.

For example, as the amperage through a resistive electrical conduit (e.g., copper wire or cable) increases, the resistivity of the resistive electrical conduit converts a portion of the electrical power to heat and other loss mechanisms. The electrical loss and heat generation are undesirable in the datacenter power system 100. Therefore, conventional systems step the voltage down in stages. In some examples, the datacenter power system 100 may include additional power sources or storage devices, such as a generator 118 and/or battery storage devices 120. In some examples, the additional power sources or storage devices, such as the generator 118 and/or battery storage devices 120, are coupled to the datacenter power system 100 at different stages of the voltage depending on the provided voltage of the additional power sources or storage devices.

In the illustrated example of FIG. 1, the datacenter power system 100 receives a high voltage grid electrical power 122 through the grid connection 110 to the high voltage transformer 112. The incoming grid electrical power 122 is received with a grid voltage, a grid amperage, and a grid frequency. In some examples, the grid voltage is a high voltage no less than 110 kilovolts (kV). In some examples, the grid voltage is an extra-high voltage no less than 345 kV. In some examples, the grid voltage is an ultra-high voltage no less than 1100 kV. Stepping down the grid voltage can produce high amperage, as the voltage and amperage are inversely proportional for a given power (Wattage), assuming limited or no losses during conversion.

For example, stepping down the grid voltage of the grid electrical power 122 through the high voltage transformer 112 to a middle voltage electrical power 124 having a middle voltage ten times less than the grid voltage results in a middle amperage ten times greater than the grid amperage. Further step-downs of the middle voltage electrical power 124 to a low voltage electrical power 126 through the middle voltage transformer 114, and of the low voltage electrical power 126 to a co-location electrical power 128 usable by the co-location 102 through the low voltage transformer 116 can continue increasing the amperage by orders of magnitude. As datacenters commonly consume electrical power on the order of Megawatts, the amperage needs to be managed at each step-down in a conventional datacenter power system 100 to avoid excessive electrical losses and heat generation.

In some embodiments, the datacenter power system 100 includes one or more electrical switches before, between, or after the transformers 112, 114, 116 and/or in the co-locations 102 to control the distribution of electrical power in the datacenter. In some embodiments, the electrical switches include liquid-based thermal management, as will be described herein, to transfer heat from the electrical switches out of the datacenter.

FIG. 2 is a schematic diagram of a datacenter power system 200 according to at least some embodiments of the present disclosure. At least a portion of the series of conventional transformers (112, 114, 116) described in relation to FIG. 1 are replaced with a solid-state transformer 230. In some embodiments, the solid-state transformer converts the high grid voltage of the grid electrical power 222 to a co-location voltage of a co-location electrical power 228 usable by a co-location 202 in a single step-down through multi-stage power electronic conversion.

The datacenter power system 200 provides the co-location electrical power 228 to the co-location 202. In some embodiments, the co-location 202 includes a PSU that receives and distributes the co-location electrical power 228 to the computing devices 204 of the co-location 202. In some embodiments, the co-location 202 does not have a PSU 206, and the co-location electrical power 228 is delivered to the plurality of computing devices 204 directly and/or without any changes to the co-location voltage, co-location amperage, co-location frequency, or combinations thereof.

In some embodiments, the co-location 202 includes a plurality of computing devices 204 in one or more server racks. In some embodiments, the co-location 202 includes a plurality of computing devices 204 in one or more server rows containing a plurality of server racks. In some embodiments, the co-location 202 includes a plurality of computing devices 204 in one or more server rooms containing a plurality of server rows. In some embodiments, the datacenter power system 200 distributes the co-location electrical power 228 to a plurality of co-locations 202.

In some embodiments, the solid-state transformer 230 is an alternating current (AC)-to-AC transformer. In some embodiments, the solid-state transformer 230 can actively regulate voltage and amperage, allowing the solid-state transformer 230 to step-down the grid voltage and also convert a grid frequency of the grid electrical power 222. In some examples, the solid-state transformer can convert single-phase AC power to three-phase AC power and/or convert three-phase AC power to single-phase AC power. In some embodiments, the solid-state transformer 230 receives an AC input power and outputs a direct current (DC) output power.

The datacenter power system 200 receives high voltage grid electrical power 222 from the utility grid 208 through a grid connection 210. The incoming grid electrical power 222 is received with a grid voltage, a grid amperage, and a grid frequency. In some embodiments, the grid voltage is a high voltage no less than 110 kV. In some embodiments, the grid voltage is an extra-high voltage no less than 345 kV. In some embodiments, the grid voltage is an ultra-high voltage no less than 1100 kV. Stepping down the grid voltage to the co-location voltage of the co-location electrical power 228 produces a high amperage, as the voltage and amperage are inversely proportional for a given power (Watts), assuming limited or no losses during conversion. With less transformers in the power train, a solid-state transformer 230 allows some embodiments of a datacenter power system 200 to be more efficient, more flexible, and with smaller and lighter power electronic systems .

In some embodiments, the co-location electrical power 228 has a co-location voltage that is no more than 240 Volts (V). In some embodiments, the co-location electrical power 228 has a co-location voltage that is no more than 120 V. In some embodiments, the co-location electrical power 228 has a co-location voltage that is no more than 48 V. In some embodiments, the co-location electrical power 228 has a co-location voltage that is no more than 12 V. In some embodiments, the co-location electrical power 228 has a co-location voltage that is no more than 5 V.

The greater the step-down in voltage across the solid-state transformer 230, the greater the increase in amperage. In some embodiments, the co-location amperage is greater than 900 times the grid amperage. To communicate the co-location electrical power 228 to the co-location(s) 202, in some embodiments, a datacenter power system 200 includes a superconducting cable 232. A superconducting cable is a wire, cable, or other electrical conduit that conducts electricity with substantially zero resistance across the length of the electrical conduit when below a critical temperature. In some embodiments, the superconducting cable 232 includes a high-temperature superconductor (HTS) with a critical temperature no less than 30 Kelvin (K). In some embodiments, the superconducting cable 232 includes an HTS with a critical temperature no less than 77 K. In some embodiments, the superconducting cable 232 includes a low-temperature superconductor with a critical temperature less than 30 K. In some embodiments, the superconducting cable 232 is cooled and/or maintained below the critical temperature using low-temperature refrigerants, such as liquid nitrogen, liquid helium, or other liquid or gas coolants, solid-state cooling, or combinations thereof.

In at least some embodiments, the superconducting cable 232 provides electrical communication of the co-location electrical power 228 from the solid-state transformer 230 to the co-location 202 directly with no intervening electrical components. In some embodiments, the superconducting cable 232 provides electrical communication for at least a portion of the electrical connection between the solid-state transformer 230 to the co-location 202. For example, and as will be described in more detail herein, the superconducting cable 232 may provide electrical communication to a second transformer or other electrical component between the solid-state transformer 230 and the co-location 202.

In some embodiments, at least a portion of the superconducting cable 232 communicates electrical power (e.g., co-location electrical power 228) having an amperage (e.g., co-location amperage) greater than 90,000 A. In some embodiments, the entire superconducting cable 232 communicates electrical power having an amperage greater than 90,000 A. For example, a grid electrical power 222 with a 110 kV grid voltage and 100 A grid amperage may be converted to a co-location electrical power 228 with a 120 V co-location voltage and an approximate 91,700 A co-location amperage. In some embodiments, at least a portion of the superconducting cable 232 communicates electrical power (e.g., co-location electrical power 228) having an amperage (e.g., co-location amperage) greater than 200,000 A. For example, a grid electrical power 222 with a 110 kV grid voltage and 100 A grid amperage may be converted to a co-location electrical power 228 with a 48 V co-location voltage and an approximate 229,000 A co-location amperage. In some embodiments, at least a portion of the superconducting cable 232 communicates electrical power (e.g., co-location electrical power 228) having an amperage (e.g., co-location amperage) greater than 2,000,000 A. For example, a grid electrical power 222 with a 110 kV grid voltage and 100 A grid amperage may be converted to a co-location electrical power 228 with a 48 V co-location voltage and an approximate 2,200,000 A co-location amperage. In some embodiments, co-location amperage could be split into multiple parallel superconducting cables each carrying a fraction of the total amperage.

A superconducting cable 232 conveys the electrical power with substantially no resistance, allowing high amperages without the associated electrical loss and heat generation of resistive conduits, such as copper wire or cable. In some embodiments, the superconducting cable 232 includes or is made of a first-generation or second-generation superconductors. First-generation superconductors include, in some examples, bismuth strontium calcium copper oxide materials. In some examples, second-generation superconductors include rare-earth barium copper oxide materials.

In some embodiments, a datacenter power system 200 including a solid-state transformer 230, a superconducting cable 232, and/or other superconducting elements distributes electrical power through the datacenter at higher amperage than conventional datacenter power systems. Electrical switches in such a datacenter power system 200 may, in some examples, experience high amperage and, therefore, higher heat generation due to resistance through the electrical switch. The datacenter power system 200, in some embodiments, includes one or more electrical switches before, between, or after the solid-state transformers 230 and/or in the co-locations 202 to control the distribution of electrical power in the datacenter. In some embodiments, the electrical switches include liquid-based thermal management, as will be described herein, to transfer heat from the electrical switches out of the datacenter.

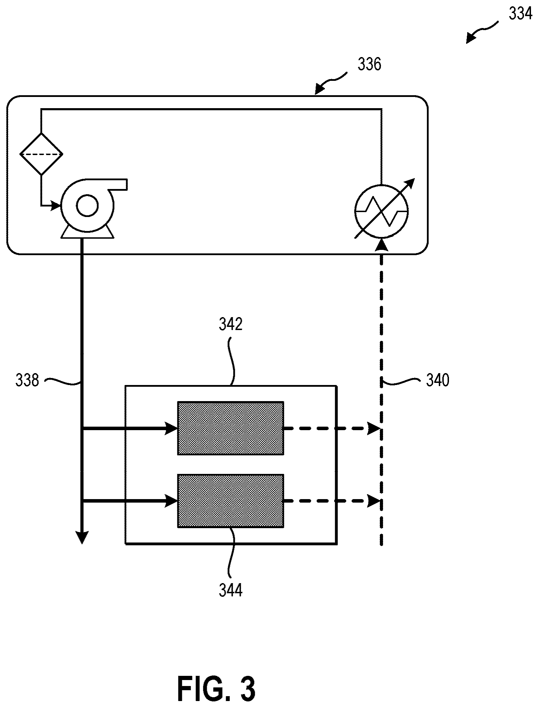

FIG. 3 is a schematic representation of a thermal management system 334 for use in a datacenter power system, such as that described in relation to FIG. 1 and/or FIG. 2. In some embodiments, the thermal management system 334 includes a coolant distribution unit (CDU) 336 that distributes a working fluid to cool one or more electronic components. In some embodiments, the working fluid flows away from the CDU 336 in a cold working fluid conduit 338. In some embodiments, after the working fluid receives heat and becomes a warm working fluid, the working fluid flows toward the CDU 336 in a warm working fluid conduit 340.

In some embodiments, the working fluid receives heat from a power electronics board 342 by flowing through a heat exchanger at or in thermal communication with the electrical switch(es) 344 connected thereto. In some embodiments, (and as will be described herein in more detail) the working fluid flows through a heat exchanger in contact with the electrical switch 344, a heat exchanger integrated into the electrical switch 344, or through a heat exchanger including microfluidic channels within a silicon layer of the electrical switch 344.

In some embodiments, the working fluid is a single-phase working fluid. For example, the working fluid may be a liquid phase in the cold working fluid conduit 338 to receive heat from the power electronics board 342 and/or the electrical switch 344 connected thereto and remain in a liquid phase when returning to the CDU 336 in the warm working fluid conduit 340. In some embodiments, the working fluid is a multi-phase working fluid, such as a dual-phase working fluid. For example, working fluid may be a liquid phase in the cold working fluid conduit 338 to receive heat from the power electronics board 342 and/or the electrical switch 344 connected thereto and vaporize to a gas phase when returning to the CDU 336 in the warm working fluid conduit 340. In such embodiments, the working fluid may receive the heat and vaporize without a substantial change in temperature of the working fluid. It should be understood that the terms "cold" and "warm" or "hot" working fluid refer to the relative overall energy present in the fluid; an increase in which may be a measurable change in temperature and/or heat absorbed in a latent heat of boiling.

In some embodiments, the electrical switch 344 is or includes a power MOSFET. In some embodiments, the electrical switch 344 is or includes a BJT. In some embodiments, the electrical switch 344 is or includes an IGBT. In some embodiments, the electrical switch 344 is any power semiconductor that generates heat during control of electrical power distribution.

The CDU 336 is in fluid communication, as described herein via the cold working fluid conduit 338 and the warm working fluid conduit 340, with the power electronics board 342 and/or the electrical switch 344 connected thereto. In some embodiments, the CDU 336 exhausts heat from the working fluid to cool the working fluid and/or condense the working fluid and create cold working fluid. For example, the CDU 336 may be in thermal communication with or be an exhaust device.

In some embodiments, the exhaust device is a heat exchanger that transfers heat from the working fluid to ambient atmosphere. In some embodiments, the exhaust device is a heat exchanger that transfers heat from the working fluid to another liquid coolant. In some embodiments, the exhaust device includes fins or mesh or other thermal feature to increase surface area of the exhaust device to atmosphere. In some embodiments, the exhaust device transfers heat from the working fluid to another liquid coolant, which then moves the heat away from the exhaust device.

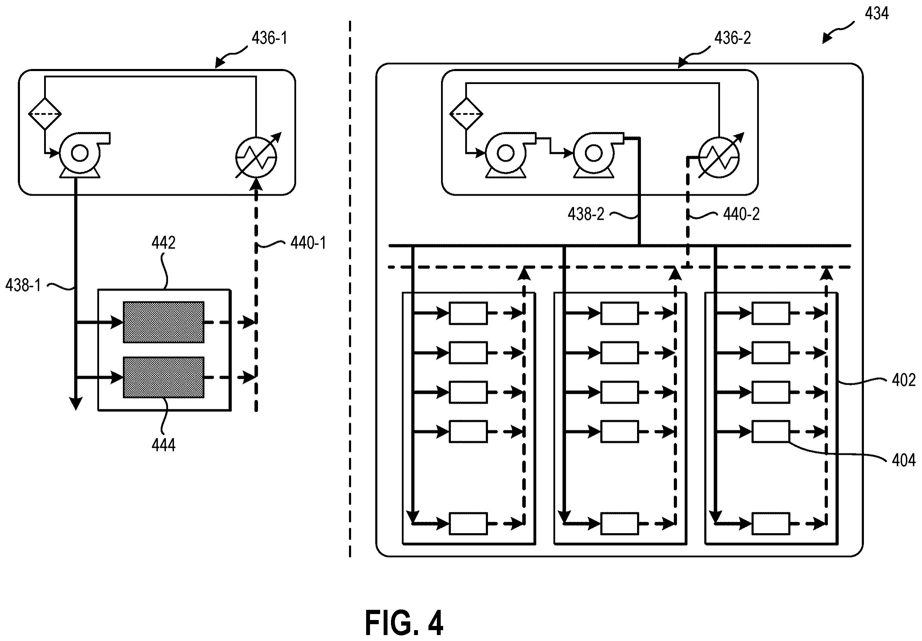

FIG. 4 is a schematic illustration of an embodiment of a thermal management system 434 including a plurality of cooling loops. In some embodiments, a thermal management system 434 includes a first cooling loop similar to and/or the same as described in relation to FIG. 3 to cool a power electronics board 442 and/or the electrical switch(es) 444 connected thereto. For example, the first cooling loop may include a first CDU 436-1 in fluid communication with a first cold working fluid conduit 438-1 and a first warm working fluid conduit 440-1 configured to circulate a first working fluid between the first CDU 436-1 and the power electronics board 442 and/or the electrical switch(es) 444 connected thereto.

In some embodiments, the thermal management system 434 further includes a second cooling loop including one or more datacenter compute resources. For example, datacenter compute resources may include co-locations 402, server computers 404, computational or processing components (graphical processing unit (GPUs), central processing units (CPUs), application specific integrated circuits (ASICs), system on chip (SOCs), and other processors), hardware storage devices (including volatile and non-volatile memory), communication devices (such as networking devices), and other electronic and electrical devices.

In some embodiments, the second cooling loop includes a second CDU 436-2 that circulates a second working fluid through a second cold working fluid conduit 438-2 and a second warm working fluid conduit 440-2. The second working fluid receives heat from the one or more datacenter compute resources, and the second CDU 436-2 exhausts the heat from the second working fluid. In some embodiments, the second working fluid is the same as the first working fluid. In some embodiments, the second working fluid is different from the first working fluid. For example, the power electronics board 442 and/or the electrical switch(es) 444 connected thereto may operate safely at a higher temperature than the datacenter compute resources. In the example of a multi-phase working fluid, the boiling temperature of the first working fluid may be higher than the boiling temperature of the second working fluid.

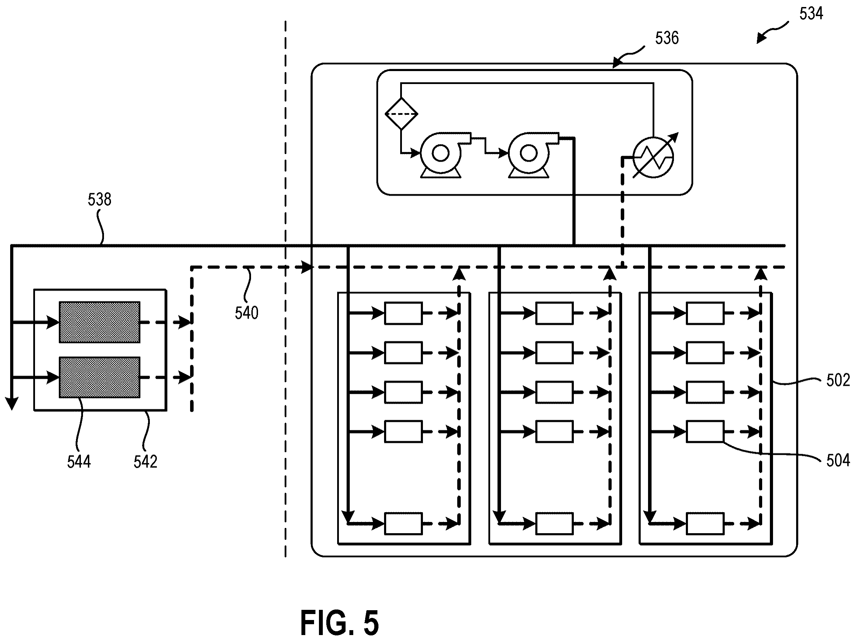

When the working fluid used to receive heat from the power electronics board 442 and/or the electrical switch(es) 444 connected thereto and the datacenter compute resources is the same, the thermal management system 434 may be simplified by the combination of the cooling loops in a parallel configuration. FIG. 5 is a schematic illustration of an embodiment of a thermal management system 534 with a power electronics board 542 and one or more co-locations 502 in parallel. For example, in embodiments such as that illustrated in FIG. 5, a single CDU 536 distributes working fluid to both a power electronics board 542 and/or the electrical switch(es) 544 connected thereto as well as to a plurality of datacenter computer resources, such as co-locations 502 containing server computers 504. The CDU 536 circulates working fluid through the power electronics board 542 and through the co-locations 502 via a cold working fluid conduit 538 that branches into a plurality of parallel conduits. The parallel cold working fluid conduits each distribute cold working fluid to a heat-generating component of the thermal management system 534, which receives heat and becomes a warm working fluid. The warm working fluid flows back toward the CDU 536 by parallel warm working fluid conduits 540 that converge.

In some embodiments, the CDU 536 is further an exhaust device that cools and/or condenses the working fluid. For example, the cold working fluid may receive heat from the datacenter compute resource and increase in temperature. The CDU 536 may exhaust heat from the warm working fluid to decrease the temperature thereof. In the parallel thermal management system 534, the cold working fluid may receive heat from the power electronics board 542 at an operating temperature greater than that of the datacenter compute resources and vaporize into a gas phase of the working fluid. The CDU may condense the warm working fluid back to a liquid phase before circulating through the thermal management system 534.

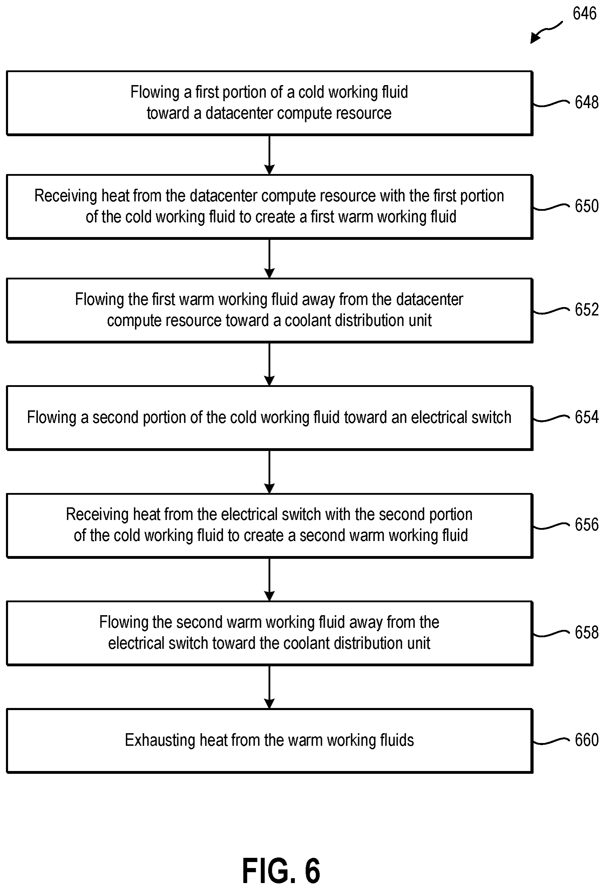

FIG. 6 is a flowchart of an embodiment of a method 646 of thermal management in parallel cooling loops, such as described in relation to FIG. 5. In some embodiments, the method 646 includes flowing a first portion of a cold working fluid toward a datacenter compute resource at 648. In some embodiments, flowing a first portion of a cold working fluid toward a datacenter compute resource includes flowing the cold working fluid to a heat sink, cold plate, microfluidic channel, or other heat exchanger of the datacenter compute resource. In some examples, datacenter compute resources may include co-locations, server computers, computational or processing components (GPUs, CPUs, ASICs, SOCs, and other processors), hardware storage devices (including volatile and non-volatile memory), communication devices (such as networking devices), and other electronic and electrical devices.

The method 646 further includes receiving heat from the datacenter compute resource with the first portion of the cold working fluid to create a first warm working fluid at 650. In some embodiments, receiving heat includes increasing a temperature of the working fluid. In some embodiments, receiving heat includes vaporizing the working fluid. In some embodiments, receiving heat includes both increasing a temperature of the working fluid and vaporizing the working fluid. The method 646 further includes flowing the warm working fluid away from the datacenter compute resource toward a CDU at 652. In some embodiments, the warm working fluid is a liquid phase. In some embodiments, the warm working fluid is at least partially a gas phase. In some embodiments, the warm working fluid flows from the datacenter computer resource to the CDU in a single warm working fluid conduit. In some embodiments, the warm working fluid flows from the datacenter compute resource to a shared conduit or other manifold where the warm working fluid from a first datacenter compute resource combines with warm working fluid from a second datacenter compute resource.

In some embodiments, the method 646 further includes flowing a second portion of the cold working fluid toward an electrical switch at 654. In some embodiments, flowing the second portion of the cold working fluid toward an electrical switch includes flowing the cold working fluid to a power electronics board. In some examples, flowing the second portion of the cold working fluid to a power electronics board includes flowing the second portion to a heat sink, cold plate, microfluidic channel, or other heat exchanger of the power electronics board. In some embodiments, flowing the second portion of the cold working fluid toward an electrical switch includes flowing the cold working fluid to the electrical switch. In some embodiments, the electrical switch is or includes a power MOSFET. In some embodiments, the electrical switch is or includes a BJT. In some embodiments, the electrical switch is or includes an IGBT. In some embodiments, the electrical switch is any power semiconductor that generates heat during control of electrical power distribution. In some examples, flowing the second portion of the cold working fluid to a power electronics board includes flowing the second portion to a heat sink, cold plate, microfluidic channel, or other heat exchanger of the power electronics board.

The method 646 further includes receiving heat from the electrical switch with the second portion of the cold working fluid to create a second warm working fluid at 656 and flowing the second warm working fluid away from the electrical switch toward the CDU at 658. In some embodiments, the second warm working fluid is a liquid phase. In some embodiments, the second warm working fluid is at least partially a gas phase. In some embodiments, the second warm working fluid flows away from the electrical switch to the CDU in a single warm working fluid conduit. In some embodiments, the second warm working fluid flows away from the electrical switch to a shared conduit or other manifold where the second warm working fluid from a first electrical switch combines with warm working fluid from a second electrical switch. In some embodiments, the second warm working fluid flows into a shared conduit and/or manifold where it combines with the first warm working fluid from the datacenter compute resource. In some embodiments, the first warm working fluid and the second warm working fluid are the same phase (such as liquid). In some embodiments, the first warm working fluid and the second warm working fluid are a different phase (such as gas and liquid).

The method 646, in some embodiments, further includes exhausting heat from the warm working fluids (e.g., first warm working fluid and second warm working fluid and/or a combined warm working fluid of the first warm working fluid and second warm working fluid) at 660. In some embodiments, the heat is exhausted at a heat exchanger of the CDU. In some embodiments, the CDU directs the warm working fluid to a separate heat exchanger that is not part of the CDU. In some embodiments, exhausting heat from the warm working fluid includes decreasing a temperature of the working fluid. In some embodiments, exhausting heat from the warm working fluid includes condensing at least a portion of the working fluid.

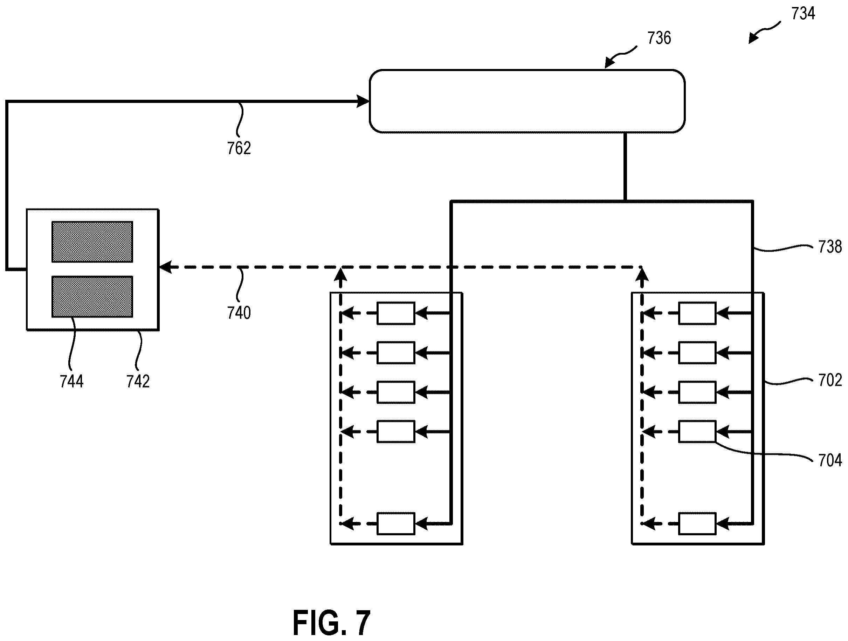

In at least some embodiments, the datacenter compute resources operate a lower temperature than the power electronics board and/or the electrical switches connected thereto. For example, the datacenter computer resources may operate most efficiently when maintained at or below a first critical temperature (e.g., less than 60°C) and the electrical switch(es) may operate up to a second critical temperature that is greater than the first critical temperature (e.g., greater than 70°C) without experiencing substantial degradation in performance or risk of damage to the components. In some embodiments, the electrical switch(es) operate at a second critical temperature greater than 100°C. Therefore, the warm working fluid exiting the datacenter compute devices may be subsequently directed to the power electronics board and/or electrical switches connected thereto to cool the electrical switch(es) below the second critical temperature. FIG. 7 is a schematic illustration of an embodiment of a thermal management system 734 with a power electronics board 742 and one or more co-locations 702 in fluidic series.

In some embodiments, the thermal management system 734 includes a CDU 736 that distributes cold working fluid through a cold working fluid conduit 738. The cold working fluid conduit is configured to direct cold working fluid from the CDU 736 to one or more datacenter compute resources. For example, datacenter compute resources may include co-locations 702, server computers 704, computational or processing components (GPUs, CPUs, ASICs, SOCs, and other processors), hardware storage devices (including volatile and non-volatile memory), communication devices (such as networking devices), and other electronic and electrical devices. The cold working fluid receives heat from the datacenter compute resource(s), increasing in temperature and/or changing phase.

A warm working fluid conduit 740 is configured to flow the warm working fluid from the datacenter compute resource(s) toward the power electronics board 742 and/or the electrical switch(es) 744 connected thereto. The warm working fluid receives additional heat from the power electronics board 742 and/or the electrical switch(es) 744 connected thereto, further increasing in temperature and/or changing phase. A hot working fluid conduit 762 then receives the hot working fluid (being higher temperature and/or higher energy than the warm working fluid). In some embodiments, the hot working fluid conduit 762 is configured to flow the hot working fluid toward the CDU 736. In some embodiments, an exhaust device of the CDU 736 is configured to decrease the temperature of the working fluid and/or condense at least a portion of the working fluid. In some embodiments, the hot working fluid conduit 762 is configured to flow the hot working fluid toward a separate heat exchanger that is not part of the CDU 736.

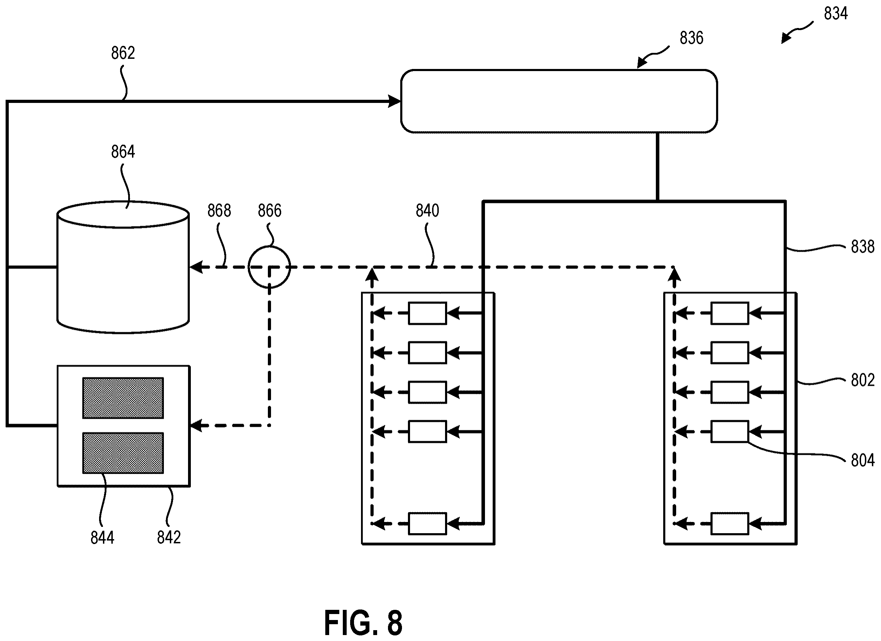

In some embodiments, the thermal management demands of the power electronics board and the datacenter compute resources are different or temporally offset. In such examples, the flow rate of working fluid through the heat exchangers of the datacenter compute resources and the power electronics board may be different. FIG. 8 is a schematic illustration of an embodiment of a thermal management system 834 with a power electronics board 842 and one or more co-locations 802 in series with a storage tank 864. In some embodiments, a valve 866 or other flow control device is configured to selectively direct flow of working fluid to the power electronics board 842 and/or the storage tank 864 based at least partially on the thermal management demands of the power electronics board 842 and/or the electrical switch(es) 844 connected thereto.

In some embodiments, the thermal management system 834 includes a CDU 836 that distributes cold working fluid through a cold working fluid conduit 838. The cold working fluid conduit is configured to direct cold working fluid from the CDU 836 to one or more datacenter compute resources. For example, datacenter compute resources may include co-locations 802, server computers 804, computational or processing components (GPUs, CPUs, ASICs, SOCs, and other processors), hardware storage devices (including volatile and non-volatile memory), communication devices (such as networking devices), and other electronic and electrical devices. The cold working fluid receives heat from the datacenter compute resource(s), increasing in temperature and/or changing phase.

A warm working fluid conduit 840 is configured to flow the warm working fluid from the datacenter compute resource(s) toward the power electronics board 842 and/or the electrical switch(es) 844 connected thereto. The warm working fluid receives additional heat from the power electronics board 842 and/or the electrical switch(es) 844 connected thereto, further increasing in temperature and/or changing phase. A hot working fluid conduit 862 then receives the hot working fluid (being higher temperature and/or higher energy than the warm working fluid). In some embodiments, the hot working fluid conduit 862 is configured to flow the hot working fluid toward the CDU 836. In some embodiments, an exhaust device of the CDU 836 is configured to decrease the temperature of the working fluid and/or condense at least a portion of the working fluid. In some embodiments, the hot working fluid conduit 862 is configured to flow the hot working fluid toward a separate heat exchanger that is not part of the CDU 836.

In some embodiments, a valve 866 is configured to selectively direct flow of the warm working fluid from the datacenter compute resources to the storage tank 864 and/or the power electronics board 842 and/or the electrical switch(es) 844 connected thereto. The valve 866 may direct working fluid through the storage conduit 868 to the storage tank 864 in addition to and/or alternatively to the power electronics board 842 and/or the electrical switch(es) 844 connected thereto.

In at least one embodiment, the valve 866 may be in data communication with the CDU 836 and/or the power electronics board 842 to selectively direct the warm working fluid based on a temperature of the power electronics board 842 and/or the electrical switch(es) 844 connected thereto. In at least one example, as the temperature of the power electronics board 842 and/or the electrical switch(es) 844 connected thereto increases, the valve 866 may be adjusted to direct a greater flowrate of warm working fluid to the power electronics board 842 and/or the electrical switch(es) 844 connected thereto. In some embodiments, the valve 866 may be in data communication with the CDU 836 and/or the power electronics board 842 to selectively direct the warm working fluid based on a power draw of the power electronics board 842 and/or the electrical switch(es) 844 connected thereto. For example, as the power draw or power flow through the electrical switch(es) 844 increases, the amount of heat generated by the electrical switch(es) 844 increases. In some embodiments, the valve 866 may be in data communication with the CDU 836 and/or the power electronics board 842 to selectively direct the warm working fluid based on a historical usage of the power electronics board 842 and/or the electrical switch(es) 844 connected thereto. For example, the power electronics board 842 and/or the electrical switch(es) 844 connected thereto may distribute a greater amount of electrical power (and generate more heat) at certain known or expected times of day, such as evenings and/or weekends. The thermal management capacity of the thermal management system 834 may be adjusted accordingly.

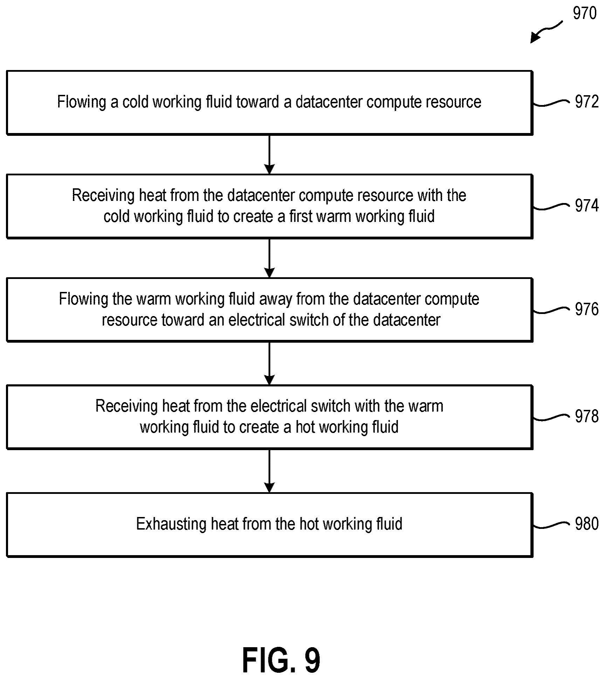

FIG. 9 is a flowchart of an embodiment of another method 968 of thermal management of a serial thermal management system such as described in relation to FIG. 7 and 8. In some embodiments, the method 970 includes flowing a cold working fluid toward a datacenter compute resource at 972 and receiving heat from the datacenter compute resource with the cold working fluid to create a warm working fluid.

In some embodiments, flowing a cold working fluid toward a datacenter compute resource includes flowing the cold working fluid to a heat sink, cold plate, microfluidic channel, or other heat exchanger of the datacenter compute resource. In some examples, datacenter compute resources may include co-locations, server computers, computational or processing components (GPUs, CPUs, ASICs, SOCs, and other processors), hardware storage devices (including volatile and non-volatile memory), communication devices (such as networking devices), and other electronic and electrical devices. In some embodiments, receiving heat includes increasing a temperature of the working fluid. In some embodiments, receiving heat includes vaporizing the working fluid. In some embodiments, receiving heat includes both increasing a temperature of the working fluid and vaporizing the working fluid.

The method 970 further includes flowing the warm working fluid away from the datacenter compute resource toward a power electronics board and/or the electrical switch(es) connected thereto at 976. In some embodiments, the method 970 includes directly only a first portion of the warm working fluid to the power electronics board and/or the electrical switch(es). In at least one embodiment, the method 970 includes directly only a first portion of the warm working fluid to the power electronics board and/or the electrical switch(es) and a second portion of the warm working fluid toward a storage tank. In some embodiments, flowing a warm working fluid toward a power electronics board and/or electrical switch(es) includes flowing the warm working fluid to a heat sink, cold plate, microfluidic channel, or other heat exchanger of the power electronics board and/or the electrical switch(es).

In some embodiments, the method 970 includes receiving heat from the electrical switch with the warm working fluid to create a hot working fluid at 978. The warm working fluid receives additional heat from the power electronics board and/or the electrical switch(es) connected thereto, further increasing in temperature and/or changing phase. A hot working fluid conduit then receives the hot working fluid (being higher temperature and/or higher energy than the warm working fluid). In some embodiments, the hot working fluid conduit is configured to flow the hot working fluid toward the CDU.

The method 970, in some embodiments, further includes exhausting heat from the warm working fluids (e.g., first warm working fluid and second warm working fluid and/or a combined warm working fluid of the first warm working fluid and second warm working fluid) at 980. In some embodiments, the heat is exhausted at a heat exchanger of the CDU. In some embodiments, the CDU directs the warm working fluid to a separate heat exchanger that is not part of the CDU. In some embodiments, exhausting heat from the warm working fluid includes decreasing a temperature of the working fluid. In some embodiments, exhausting heat from the warm working fluid includes condensing at least a portion of the working fluid.

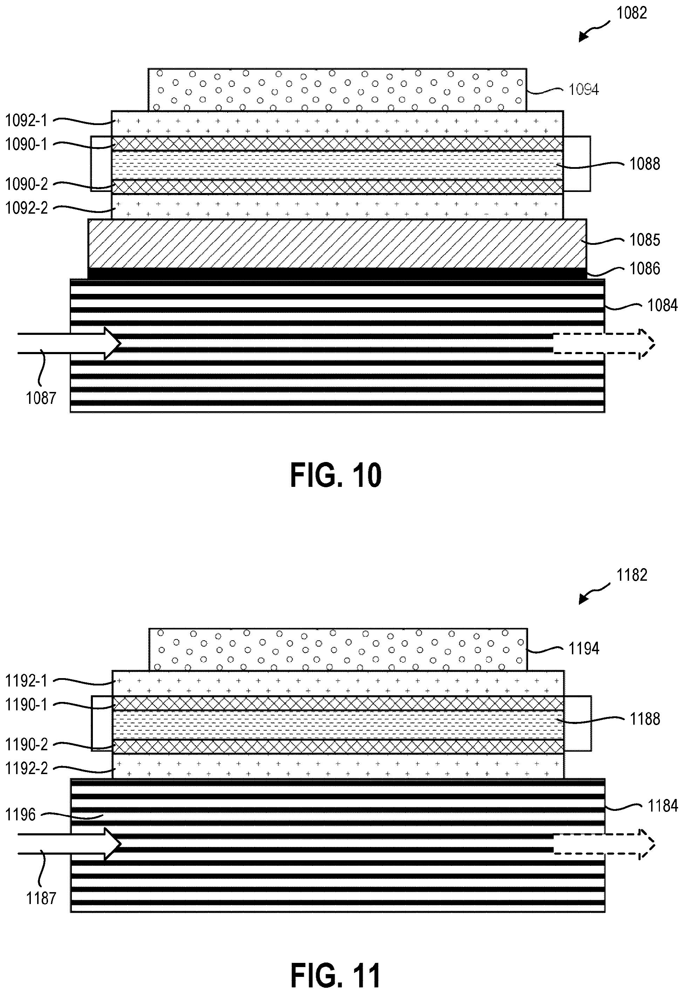

As described herein, the electrical switch may transfer heat to the working fluid through a thermal interface and/or through a thermally conductive material that is between the electrical switch and the working fluid. FIG. 10 is a side cross-sectional view of an embodiment of an IGBT 1082 with a cold plate 1084. In some embodiments, the IGBT 1082 includes a base plate 1085 that is in thermal communication, via a thermal interface material (TIM) 1086, with the cold plate 1084. In some embodiments, the cold plate receives cold working fluid 1087 and transfers heat from the IGBT 1082 to the working fluid 1087 to create a warm working fluid 1087. In some embodiments, the cold plate receives warm working fluid 1087 and transfers heat from the IGBT 1082 to the working fluid 1087 to create a hot working fluid 1087. In some embodiments, the working fluid 1087 increases in temperature. In some embodiments, at least a portion of the working fluid 1087 vaporizes.

In some embodiments, the IGBT 1082 includes a substrate 1088 that is positioned between copper layers 1090 above and below the substrate 1088. The first copper layer 1090-1 is connected to a silicon layer 1094 by a first solder layer 1092-1, and the second copper layer 1090-2 is connected to the base plate 1085 by a second solder layer 1092-1.

FIG. 11 is a side cross-sectional view of an IGBT 1182 with integrated liquid-based cooling in the base plate 1185. In some embodiments, the IGBT 1182 includes a substrate 1188 that is positioned between copper layers 1190 above and below the substrate 1188. The first copper layer 1190-1 is connected to a silicon layer 1194 by a first solder layer 1192-1, and the second copper layer 1190-2 is connected to the base plate 1185 by a second solder layer 1192-1.

In some embodiments, the base plate 1185 includes one or more channels 1196, grooves, or other fluid conduits through or in at least a portion of the base plate 1185. The channels 1196 are configured to receive working fluid 1187 and flow the working fluid through the base plate 1185, which removes the interfaces with the TIM and cold plate, described in relation to FIG. 10, increasing efficiency of thermal transfer from the IGBT 1182.

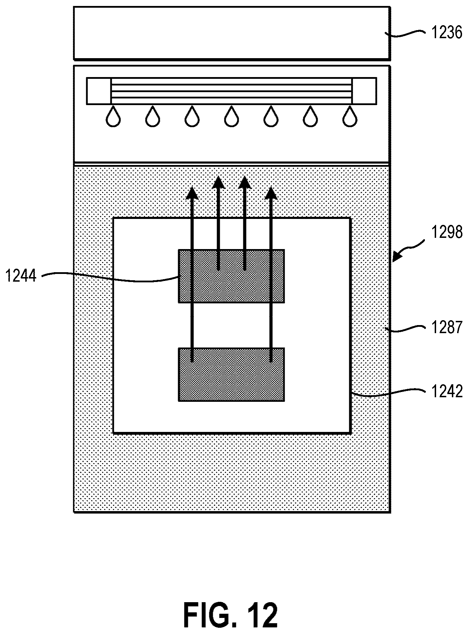

In some embodiments, the liquid-based thermal management of the electrical switch(es) includes immersion cooling of the electrical switch(es). FIG. 12 is a perspective view of a power electronics board 1242 and electrical switches 1244 immersion cooled. In some embodiments, the power electronics board 1242 and electrical switches 1244 are located in an immersion tank 1298 and at least partially immersed in working fluid 1287. For example, the working fluid 1287 may be a dual-phase working fluid 1287 that vaporizes based at least partially on the heat from the power electronics board 1242 and electrical switches 1244. The gas phase of the working fluid 1287 is condensed, for example, by the CDU 1236, and returned to the immersion tank 1298. In some embodiments, the CDU 1236 exhausts the heat.

### INDUSTRIAL APPLICABILITY

The present disclosure generally relates to systems and methods for providing electrical power to a datacenter. In some embodiments, a datacenter power system according to the present disclosure provides more stable and/or higher power delivery from a utility grid to server computers and other electrical devices in a datacenter. More particularly, a datacenter power system, in some embodiments, includes a liquid-cooled electrical switch to manage heat generated during electrical power delivery to portions of the datacenter. For example, the datacenter power system may include a liquid-cooled electrical switch, such as a power metal-oxide semiconductor field effect transistor (MOSFET), bipolar junction transistor (BJT), and/or an insulated gate bipolar transistor (IGBT) switch.

In some examples, an electrical switch generates heat while electrical current flows therethrough. At least a portion of the electrical power in the current is dissipated as heat into the switch. In some examples, a higher amperage current generates a greater amount of heat in the switch. As datacenters increase in capacity and demand, the amperage of the electrical power to co-locations, compute resources, network modules, storage device, power distribution units (PDUs), heating, ventilation, and air conditioning (HVAC) systems, and other portions of datacenters may increase. In some embodiments, thermal management of an electrical switch in or for a datacenter allows for greater electrical power to be delivered to portions of the datacenter and overall computational capacity of the datacenter to increase.

In some embodiments, thermal management of an electrical switch in or for a datacenter allows for a smaller footprint of the datacenter and/or greater flexibility in datacenter design and location. For example, air cooling of heat-generating components of a datacenter can limit the datacenter design and/or location. Air cooling of the heat-generating components can require comparatively large ducting in the datacenter structure relative to a liquid conduit to move heat from the electrical switch or other heat-generating components to an exhaust device. In some examples, air cooling of the heat-generating components needs relatively large air handling units (AHU) to cool the interior air of the datacenter. In some embodiments, systems and methods according to the present disclosure exhaust heat from the electrical switches to a working fluid without substantially heating the interior air. In some examples, air cooling of the heat-generating components requires ducting access to exhaust hot air to ambient atmosphere outside of the datacenter. In some embodiments, systems and methods according to the present disclosure transfer heat to an exhaust device by a working fluid.

In some embodiments, a thermal management system including liquid-cooling of electrical switches allows more design flexibility for edge-of-cloud (EOC) datacenters and other datacenters with small footprints and/or datacenters located closer to developed areas. For example, on undeveloped land, a datacenter can utilize air cooling or utilize the large-volume ducting for air cooling of the heat-generating components. In smaller footprint datacenters, such as EOC datacenters, the installation of compute resources and other heat-generating components may be restricted to smaller buildings, existing buildings lacking HVAC capacity for a datacenter, and/or portions of buildings without access to atmosphere exhaust (e.g., basements. Liquid cooling of electrical switches can allow more efficient and/or greater capacity heat transfer from the datacenter to atmosphere or other exhausts.

In some embodiments, the thermal management system includes a coolant distribution unit (CDU) that distributes a working fluid to cool one or more electronic components. In some embodiments, the working fluid flows away from the CDU in a cold working fluid conduit. In some embodiments, after the working fluid receives heat and becomes a warm working fluid, the working fluid flows toward the CDU in a warm working fluid conduit.

In some embodiments, the working fluid receives heat from a power electronics board by flowing through a heat exchanger at or in thermal communication with the electrical switch(es) connected thereto. In some embodiments, (and as will be described herein in more detail) the working fluid flows through a heat exchanger in contact with the electrical switch, a heat exchanger integrated into the electrical switch, or through a heat exchanger including microfluidic channels within a silicon layer of the electrical switch.

In some embodiments, the working fluid is a single-phase working fluid. For example, the working fluid may be a liquid phase in the cold working fluid conduit to receive heat from the power electronics board and/or the electrical switch connected thereto and remain in a liquid phase when returning to the CDU in the warm working fluid conduit. In some embodiments, the working fluid is a multi-phase working fluid, such as a dual-phase working fluid. For example, working fluid may be a liquid phase in the cold working fluid conduit to receive heat from the power electronics board and/or the electrical switch connected thereto and vaporize to a gas phase when returning to the CDU in the warm working fluid conduit. In such embodiments, the working fluid may receive the heat and vaporize without a substantial change in temperature of the working fluid. It should be understood that the terms "cold" and "warm" or "hot" working fluid refer to the relative overall energy present in the fluid; an increase in which may be a measurable change in temperature and/or heat absorbed in a latent heat of boiling.

In some embodiments, the electrical switch is or includes a power MOSFET. In some embodiments, the electrical switch is or includes a BJT. In some embodiments, the electrical switch is or includes an IGBT. In some embodiments, the electrical switch is any power semiconductor that generates heat during control of electrical power distribution.

The CDU is in fluid communication, as described herein via the cold working fluid conduit and the warm working fluid conduit, with the power electronics board and/or the electrical switch connected thereto. In some embodiments, the CDU exhausts heat from the working fluid to cool the working fluid and/or condense the working fluid and create cold working fluid. For example, the CDU may be in thermal communication with or be an exhaust device.

In some embodiments, the exhaust device is a heat exchanger that transfers heat from the working fluid to ambient atmosphere. In some embodiments, the exhaust device is a heat exchanger that transfers heat from the working fluid to another liquid coolant. In some embodiments, the exhaust device includes fins or mesh or other thermal feature to increase surface area of the exhaust device to atmosphere. In some embodiments, the exhaust device transfers heat from the working fluid to another liquid coolant, which then moves the heat away from the exhaust device.

In some embodiments, a thermal management device includes a first cooling loop similar to and/or the same as described herein to cool a power electronics board and/or the electrical switch(es) connected thereto. For example, the first cooling loop may include a first CDU in fluid communication with a first cold working fluid conduit and a first warm working fluid conduit configured to circulate a first working fluid between the first CDU and the power electronics board and/or the electrical switch(es) connected thereto.

In some embodiments, the thermal management system further includes a second cooling loop including one or more datacenter compute resources. For example, datacenter compute resources may include co-locations, server computers, computational or processing components (graphical processing unit (GPUs), central processing units (CPUs), application specific integrated circuits (ASICs), system on chip (SOCs), and other processors), hardware storage devices (including volatile and non-volatile memory), communication devices (such as networking devices), and other electronic and electrical devices.

In some embodiments, the second cooling loop includes a second CDU that circulates a second working fluid through a second cold working fluid conduit and a second warm working fluid conduit. The second working fluid receives heat from the one or more datacenter compute resources, and the second CDU exhausts the heat from the second working fluid. In some embodiments, the second working fluid is the same as the first working fluid. In some embodiments, the second working fluid is different from the first working fluid. For example, the power electronics board and/or the electrical switch(es) connected thereto may operate safely at a higher temperature than the datacenter compute resources. In the example of a multi-phase working fluid, the boiling temperature of the first working fluid may be higher than the boiling temperature of the second working fluid.

When the working fluid used to receive heat from the power electronics board and/or the electrical switch(es) connected thereto and the datacenter compute resources is the same, the thermal management system may be simplified by the combination of the cooling loops in a parallel configuration. For example, in embodiments, a single CDU distributes working fluid to both a power electronics board and/or the electrical switch(es) connected thereto as well as to a plurality of datacenter computer resources, such as co-locations containing server computers. The CDU circulates working fluid through the power electronics board and through the co-locations via a cold working fluid conduit that branches into a plurality of parallel conduits. The parallel cold working fluid conduits each distribute cold working fluid to a heat-generating component of the thermal management system, which receives heat and becomes a warm working fluid. The warm working fluid flows back toward the CDU by parallel warm working fluid conduits that converge.

In some embodiments, the CDU is further an exhaust device that cools and/or condenses the working fluid. For example, the cold working fluid may receive heat from the datacenter compute resource and increase in temperature. The CDU may exhaust heat from the warm working fluid to decrease the temperature thereof. In the parallel thermal management system, the cold working fluid may receive heat from the power electronics board at an operating temperature greater than that of the datacenter compute resources and vaporize into a gas phase of the working fluid. The CDU may condense the warm working fluid back to a liquid phase before circulating through the thermal management system.

In some embodiments, a method of thermal management in parallel cooling loops, such as described herein, includes flowing a first portion of a cold working fluid toward a datacenter compute resource. In some embodiments, flowing a first portion of a cold working fluid toward a datacenter compute resource includes flowing the cold working fluid to a heat sink, cold plate, microfluidic channel, or other heat exchanger of the datacenter compute resource. In some examples, datacenter compute resources may include co-locations, server computers, computational or processing components (GPUs, CPUs, ASICs, SOCs, and other processors), hardware storage devices (including volatile and non-volatile memory), communication devices (such as networking devices), and other electronic and electrical devices.

The method further includes receiving heat from the datacenter compute resource with the first portion of the cold working fluid to create a first warm working fluid. In some embodiments, receiving heat includes increasing a temperature of the working fluid. In some embodiments, receiving heat includes vaporizing the working fluid. In some embodiments, receiving heat includes both increasing a temperature of the working fluid and vaporizing the working fluid. The method further includes flowing the warm working fluid away from the datacenter compute resource toward a CDU. In some embodiments, the warm working fluid is a liquid phase. In some embodiments, the warm working fluid is at least partially a gas phase. In some embodiments, the warm working fluid flows from the datacenter computer resource to the CDU in a single warm working fluid conduit. In some embodiments, the warm working fluid flows from the datacenter compute resource to a shared conduit or other manifold where the warm working fluid from a first datacenter compute resource combines with warm working fluid from a second datacenter compute resource.

In some embodiments, the method further includes flowing a second portion of the cold working fluid toward an electrical switch. In some embodiments, flowing the second portion of the cold working fluid toward an electrical switch includes flowing the cold working fluid to a power electronics board. In some examples, flowing the second portion of the cold working fluid to a power electronics board includes flowing the second portion to a heat sink, cold plate, microfluidic channel, or other heat exchanger of the power electronics board. In some embodiments, flowing the second portion of the cold working fluid toward an electrical switch includes flowing the cold working fluid to the electrical switch. In some embodiments, the electrical switch is or includes a power MOSFET. In some embodiments, the electrical switch is or includes a BJT. In some embodiments, the electrical switch is or includes an IGBT. In some embodiments, the electrical switch is any power semiconductor that generates heat during control of electrical power distribution. In some examples, flowing the second portion of the cold working fluid to a power electronics board includes flowing the second portion to a heat sink, cold plate, microfluidic channel, or other heat exchanger of the power electronics board.

The method further includes receiving heat from the electrical switch with the second portion of the cold working fluid to create a second warm working fluid and flowing the second warm working fluid away from the electrical switch toward the CDU. In some embodiments, the second warm working fluid is a liquid phase. In some embodiments, the second warm working fluid is at least partially a gas phase. In some embodiments, the second warm working fluid flows away from the electrical switch to the CDU in a single warm working fluid conduit. In some embodiments, the second warm working fluid flows away from the electrical switch to a shared conduit or other manifold where the second warm working fluid from a first electrical switch combines with warm working fluid from a second electrical switch. In some embodiments, the second warm working fluid flows into a shared conduit and/or manifold where it combines with the first warm working fluid from the datacenter compute resource. In some embodiments, the first warm working fluid and the second warm working fluid are the same phase (such as liquid). In some embodiments, the first warm working fluid and the second warm working fluid are a different phase (such as gas and liquid).

The method, in some embodiments, further includes exhausting heat from the warm working fluids (e.g., first warm working fluid and second warm working fluid and/or a combined warm working fluid of the first warm working fluid and second warm working fluid). In some embodiments, the heat is exhausted at a heat exchanger of the CDU. In some embodiments, the CDU directs the warm working fluid to a separate heat exchanger that is not part of the CDU. In some embodiments, exhausting heat from the warm working fluid includes decreasing a temperature of the working fluid. In some embodiments, exhausting heat from the warm working fluid includes condensing at least a portion of the working fluid.

In at least some embodiments, the datacenter compute resources operate a lower temperature than the power electronics board and/or the electrical switches connected thereto. For example, the datacenter computer resources may operate most efficiently when maintained at or below a first critical temperature (e.g., less than 60°C) and the electrical switch(es) may operate up to a second critical temperature that is greater than the first critical temperature (e.g., greater than 70°C) without experiencing substantial degradation in performance or risk of damage to the components. In some embodiments, the electrical switch(es) operate at a second critical temperature greater than 100°C. Therefore, the warm working fluid exiting the datacenter compute devices may be subsequently directed to the power electronics board and/or electrical switches connected thereto to cool the electrical switch(es) below the second critical temperature.

In some embodiments, the thermal management system includes a CDU that distributes cold working fluid through a cold working fluid conduit. The cold working fluid conduit is configured to direct cold working fluid from the CDU to one or more datacenter compute resources. For example, datacenter compute resources may include co-locations, server computers, computational or processing components (GPUs, CPUs, ASICs, SOCs, and other processors), hardware storage devices (including volatile and non-volatile memory), communication devices (such as networking devices), and other electronic and electrical devices. The cold working fluid receives heat from the datacenter compute resource(s), increasing in temperature and/or changing phase.

A warm working fluid conduit is configured to flow the warm working fluid from the datacenter compute resource(s) toward the power electronics board and/or the electrical switch(es) connected thereto. The warm working fluid receives additional heat from the power electronics board and/or the electrical switch(es) connected thereto, further increasing in temperature and/or changing phase. A hot working fluid conduit then receives the hot working fluid (being higher temperature and/or higher energy than the warm working fluid). In some embodiments, the hot working fluid conduit is configured to flow the hot working fluid toward the CDU. In some embodiments, an exhaust device of the CDU is configured to decrease the temperature of the working fluid and/or condense at least a portion of the working fluid. In some embodiments, the hot working fluid conduit is configured to flow the hot working fluid toward a separate heat exchanger that is not part of the CDU.

In some embodiments, the thermal management demands of the power electronics board and the datacenter compute resources are different or temporally offset. In such examples, the flow rate of working fluid through the heat exchangers of the datacenter compute resources and the power electronics board may be different. In some embodiments, a thermal management system includes a power electronics board and one or more co-locations in series with a storage tank. In some embodiments, a valve or other flow control device is configured to selectively direct flow of working fluid to the power electronics board and/or the storage tank based at least partially on the thermal management demands of the power electronics board and/or the electrical switch(es) connected thereto.

In some embodiments, the thermal management system includes a CDU that distributes cold working fluid through a cold working fluid conduit. The cold working fluid conduit is configured to direct cold working fluid from the CDU to one or more datacenter compute resources. For example, datacenter compute resources may include co-locations, server computers, computational or processing components (GPUs, CPUs, ASICs, SOCs, and other processors), hardware storage devices (including volatile and non-volatile memory), communication devices (such as networking devices), and other electronic and electrical devices. The cold working fluid receives heat from the datacenter compute resource(s), increasing in temperature and/or changing phase.

A warm working fluid conduit is configured to flow the warm working fluid from the datacenter compute resource(s) toward the power electronics board and/or the electrical switch(es) connected thereto. The warm working fluid receives additional heat from the power electronics board and/or the electrical switch(es) connected thereto, further increasing in temperature and/or changing phase. A hot working fluid conduit then receives the hot working fluid (being higher temperature and/or higher energy than the warm working fluid). In some embodiments, the hot working fluid conduit is configured to flow the hot working fluid toward the CDU. In some embodiments, an exhaust device of the CDU is configured to decrease the temperature of the working fluid and/or condense at least a portion of the working fluid. In some embodiments, the hot working fluid conduit is configured to flow the hot working fluid toward a separate heat exchanger that is not part of the CDU.

In some embodiments, a valve is configured to selectively direct flow of the warm working fluid from the datacenter compute resources to the storage tank and/or the power electronics board and/or the electrical switch(es) connected thereto. The valve may direct working fluid through the storage conduit to the storage tank in addition to and/or alternatively to the power electronics board and/or the electrical switch(es) connected thereto.

In at least one embodiment, the valve may be in data communication with the CDU and/or the power electronics board to selectively direct the warm working fluid based on a temperature of the power electronics board and/or the electrical switch(es) connected thereto. In at least one example, as the temperature of the power electronics board and/or the electrical switch(es) connected thereto increases, the valve may be adjusted to direct a greater flowrate of warm working fluid to the power electronics board and/or the electrical switch(es) connected thereto. In some embodiments, the valve may be in data communication with the CDU and/or the power electronics board to selectively direct the warm working fluid based on a power draw of the power electronics board and/or the electrical switch(es) connected thereto. For example, as the power draw or power flow through the electrical switch(es) increases, the amount of heat generated by the electrical switch(es) increases. In some embodiments, the valve may be in data communication with the CDU and/or the power electronics board to selectively direct the warm working fluid based on a historical usage of the power electronics board and/or the electrical switch(es) connected thereto. For example, the power electronics board and/or the electrical switch(es) connected thereto may distribute a greater amount of electrical power (and generate more heat) at certain known or expected times of day, such as evenings and/or weekends. The thermal management capacity of the thermal management system may be adjusted accordingly.

In some embodiments, a method of thermal management of a serial thermal management system includes flowing a cold working fluid toward a datacenter compute resource and receiving heat from the datacenter compute resource with the cold working fluid to create a warm working fluid.

In some embodiments, flowing a cold working fluid toward a datacenter compute resource includes flowing the cold working fluid to a heat sink, cold plate, microfluidic channel, or other heat exchanger of the datacenter compute resource. In some examples, datacenter compute resources may include co-locations, server computers, computational or processing components (GPUs, CPUs, ASICs, SOCs, and other processors), hardware storage devices (including volatile and non-volatile memory), communication devices (such as networking devices), and other electronic and electrical devices. In some embodiments, receiving heat includes increasing a temperature of the working fluid. In some embodiments, receiving heat includes vaporizing the working fluid. In some embodiments, receiving heat includes both increasing a temperature of the working fluid and vaporizing the working fluid.

The method further includes flowing the warm working fluid away from the datacenter compute resource toward a power electronics board and/or the electrical switch(es) connected thereto. In some embodiments, the method includes directly only a first portion of the warm working fluid to the power electronics board and/or the electrical switch(es). In at least one embodiment, the method includes directly only a first portion of the warm working fluid to the power electronics board and/or the electrical switch(es) and a second portion of the warm working fluid toward a storage tank. In some embodiments, flowing a warm working fluid toward a power electronics board and/or electrical switch(es) includes flowing the warm working fluid to a heat sink, cold plate, microfluidic channel, or other heat exchanger of the power electronics board and/or the electrical switch(es).

In some embodiments, the method includes receiving heat from the electrical switch with the warm working fluid to create a hot working fluid. The warm working fluid receives additional heat from the power electronics board and/or the electrical switch(es) connected thereto, further increasing in temperature and/or changing phase. A hot working fluid conduit then receives the hot working fluid (being higher temperature and/or higher energy than the warm working fluid). In some embodiments, the hot working fluid conduit is configured to flow the hot working fluid toward the CDU.

The method, in some embodiments, further includes exhausting heat from the warm working fluids (e.g., first warm working fluid and second warm working fluid and/or a combined warm working fluid of the first warm working fluid and second warm working fluid). In some embodiments, the heat is exhausted at a heat exchanger of the CDU. In some embodiments, the CDU directs the warm working fluid to a separate heat exchanger that is not part of the CDU. In some embodiments, exhausting heat from the warm working fluid includes decreasing a temperature of the working fluid. In some embodiments, exhausting heat from the warm working fluid includes condensing at least a portion of the working fluid.

As described herein, the electrical switch may transfer heat to the working fluid through a thermal interface and/or through a thermally conductive material that is between the electrical switch and the working fluid. In some embodiments, the IGBT includes a base plate that is in thermal communication, via a thermal interface material (TIM), with a cold plate. In some embodiments, the cold plate receives cold working fluid and transfers heat from the IGBT to the working fluid to create a warm working fluid. In some embodiments, the cold plate receives warm working fluid and transfers heat from the IGBT to the working fluid to create a hot working fluid. In some embodiments, the working fluid increases in temperature. In some embodiments, at least a portion of the working fluid vaporizes.

In some embodiments, the IBGT includes a substrate that is positioned between copper layers above and below the substrate. The first copper layer is connected to a silicon layer by a first solder layer, and the second copper layer is connected to the base plate by a second solder layer.

In some embodiments, the base plate includes one or more channels, grooves, or other fluid conduits through or in at least a portion of the base plate. The channels are configured to receive working fluid and flow the working fluid through the base plate, which removes the interfaces with the TIM and cold plate, increasing efficiency of thermal transfer from the IGBT.

In some embodiments, the liquid-based thermal management of the electrical switch(es) includes immersion cooling of the electrical switch(es). In some embodiments, the power electronics board and electrical switches are located in an immersion tank and at least partially immersed in working fluid. For example, the working fluid may be a dual-phase working fluid that vaporizes based at least partially on the heat from the power electronics board and electrical switches. The gas phase of the working fluid is condensed, for example, by the CDU, and returned to the immersion tank. In some embodiments, the CDU exhausts the heat.

As provided therein, a system may include an electrical switch. A system may include a heat exchanger in thermal communication with the electrical switch and configured to receive heat from the electrical switch. A system may include a liquid cooling conduit configured to flow a working fluid therethrough, wherein the liquid cooling conduit is in thermal communication with the heat exchanger and configured to receive heat from the heat exchanger. A system may include an exhaust device in fluid communication with the liquid cooling conduit and configured to exhaust heat from the working fluid. The present disclosure relates to systems and methods for providing electrical power in a datacenter according to at least the examples provided in the clauses below:
Clause 1. A system for electrical power management, the system comprising: an electrical switch; a heat exchanger in thermal communication with the electrical switch and configured to receive heat from the electrical switch; a liquid cooling conduit configured to flow a working fluid therethrough, wherein the liquid cooling conduit is in thermal communication with the heat exchanger and configured to receive heat from the heat exchanger; and an exhaust device in fluid communication with the liquid cooling conduit and configured to exhaust heat from the working fluid.
Clause 2. The system of clause 1, wherein the electrical switch is an IGBT.
Clause 3. The system of clause 1, wherein the electrical switch is configured to provide electrical power to a datacenter compute resource.
Clause 4. The system of clause 1, wherein the liquid cooling conduit is configured to communicate a working fluid to a second heat exchanger, and wherein the working fluid is configured to receive heat from the second heat exchanger before the exhaust device.
Clause 5. The system of clause 4, wherein the second heat exchanger receives heat from a datacenter compute resource.
Clause 6. The system of clause 1, wherein the working fluid is a multi-phase working fluid and the exhaust device includes a condenser.
Clause 7. The system of clause 1, wherein the liquid cooling conduit is a first liquid cooling conduit, and further comprising a cooling distribution unit (CDU) configured to distribute working fluid to the first liquid cooling conduit and a second cooling conduit.
Clause 8. The system of clause 7, wherein the second cooling conduit is configured to receive heat from a datacenter compute resource.
Clause 9. The system of clause 7, wherein the second cooling conduit is configured to receive heat from a second electrical switch.
Clause 10. A method of thermal management in a datacenter, the method comprising: flowing a cold working fluid toward a datacenter compute resource; receiving heat from the datacenter compute resource with the cold working fluid to create a warm working fluid; flowing the warm working fluid away from the datacenter compute resource toward an electrical switch of the datacenter; receiving heat from the electrical switch with the warm working fluid to create a hot working fluid; and exhausting heat from the hot working fluid.
Clause 11. The method of clause 10, wherein the hot working fluid is a gas phase working fluid.
Clause 12. The method of clause 10, wherein flowing the warm working fluid away from the datacenter compute resource toward an electrical switch of the datacenter includes flowing a first portion of the warm working fluid away from the datacenter compute resource toward an electrical switch and directing at least a second portion of the warm working fluid toward a storage tank.
Clause 13. The method of clause 12, wherein flowing the first portion of the warm working fluid toward the electrical switch is based at least partially on a temperature of the electrical switch.
Clause 14. The method of clause 12, wherein flowing the first portion of the warm working fluid toward the electrical switch is based at least partially on a power draw of the electrical switch.
Clause 15. The method of clause 12, wherein flowing the first portion of the warm working fluid toward the electrical switch is based at least partially on a historical thermal management demand of the electrical switch.
Clause 16. The method of clause 12, wherein flowing the first portion of the warm working fluid toward the electrical switch is based at least partially on a power draw of the datacenter compute resource.
Clause 17. A method of thermal management in a datacenter, the method comprising: flowing a first portion of a cold working fluid toward a datacenter compute resource; receiving heat from the datacenter compute resource with the first portion of the cold working fluid to create a first warm working fluid; flowing the first warm working fluid away from the datacenter compute resource toward a coolant distribution unit (CDU); flowing a second portion of a cold working fluid toward an electrical switch; receiving heat from the datacenter compute resource with the second portion of the cold working fluid to create a second warm working fluid; flowing the second warm working fluid away from the electrical switch toward the CDU; and exhausting heat from the warm working fluids.
Clause 18. The method of clause 17, wherein the electrical switch is an IGBT.
Clause 19. The method of clause 17, wherein exhausting heat from the warm working fluids includes exhausting heat from the CDU.
Clause 20. The method of clause 17, wherein exhausting heat from the warm working fluids includes condensing at least a portion of the warm working fluids.

The articles "a," "an," and "the" are intended to mean that there are one or more of the elements in the preceding descriptions. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. For example, any element described in relation to an embodiment herein may be combinable with any element of any other embodiment described herein. Numbers, percentages, ratios, or other values stated herein are intended to include that value, and also other values that are "about" or "approximately" the stated value, as would be appreciated by one of ordinary skill in the art encompassed by embodiments of the present disclosure. A stated value should therefore be interpreted broadly enough to encompass values that are at least close enough to the stated value to perform a desired function or achieve a desired result. The stated values include at least the variation to be expected in a suitable manufacturing or production process, and may include values that are within 5%, within 1%, within 0.1%, or within 0.01% of a stated value.
A person having ordinary skill in the art should realize in view of the present disclosure that equivalent constructions do not depart from the scope of the present disclosure, and that various changes, substitutions, and alterations may be made to embodiments disclosed herein without departing from the scope of the present disclosure. Equivalent constructions, including functional "means-plus-function" sections are intended to cover the structures described herein as performing the recited function, including both structural equivalents that operate in the same manner, and equivalent structures that provide the same function. It is the express intention of the applicant not to invoke means-plus-function or other functional claiming for any claim except for those in which the words 'means for' appear together with an associated function. Each addition, deletion, and modification to the embodiments that falls within the meaning and scope of the claims is to be embraced by the claims.
It should be understood that any directions or reference frames in the preceding description are merely relative directions or movements. For example, any references to "front" and "back" or "top" and "bottom" or "left" and "right" are merely descriptive of the relative position or movement of the related elements.
The present disclosure may be embodied in other specific forms without departing from its characteristics. The described embodiments are to be considered as illustrative and not restrictive. The scope of the disclosure is, therefore, indicated by the appended claims rather than by the foregoing description. Changes that come within the meaning and range of equivalency of the claims are to be embraced within their scope.

## Claims

1. A system for electrical power management, the system comprising:
an electrical switch (344);
a heat exchanger (342) in thermal communication with the electrical switch and configured to receive heat from the electrical switch;
a liquid cooling conduit (340) configured to flow a working fluid therethrough, wherein the liquid cooling conduit is in thermal communication with the heat exchanger and configured to receive heat from the heat exchanger; and
an exhaust device (336) in fluid communication with the liquid cooling conduit and configured to exhaust heat from the working fluid.

2. The system of claim 1, wherein the electrical switch is an IGBT.

3. The system of claim 1 or 2, wherein the electrical switch is configured to provide electrical power to a datacenter compute resource.

4. The system of any preceding claim, wherein the liquid cooling conduit is configured to communicate a working fluid to a second heat exchanger, and wherein the working fluid is configured to receive heat from the second heat exchanger before the exhaust device.

5. The system of claim 4, wherein the second heat exchanger receives heat from a datacenter compute resource.

6. The system of any preceding claim, wherein the working fluid is a multi-phase working fluid and the exhaust device includes a condenser.

7. The system of any preceding claim, wherein the liquid cooling conduit is a first liquid cooling conduit, and
further comprising a cooling distribution unit, CDU, configured to distribute working fluid to the first liquid cooling conduit and a second cooling conduit.

8. The system of claim 7, wherein the second cooling conduit is configured to receive heat from a datacenter compute resource.

9. The system of claim 7, wherein the second cooling conduit is configured to receive heat from a second electrical switch.

10. A method of thermal management in a datacenter, the method comprising:
flowing (972) a cold working fluid toward a datacenter compute resource;
receiving (974) heat from the datacenter compute resource with the cold working fluid to create a warm working fluid;
flowing (976) the warm working fluid away from the datacenter compute resource toward an electrical switch of the datacenter;
receiving (978) heat from the electrical switch with the warm working fluid to create a hot working fluid; and
exhausting (980) heat from the hot working fluid.

11. The method of claim 10, wherein the hot working fluid is a gas phase working fluid.

12. The method of claim 10 or 11, wherein flowing the warm working fluid away from the datacenter compute resource toward an electrical switch of the datacenter includes flowing a first portion of the warm working fluid away from the datacenter compute resource toward an electrical switch and directing at least a second portion of the warm working fluid toward a storage tank.

13. The method of claim 12, wherein flowing the first portion of the warm working fluid toward the electrical switch is based at least partially on a temperature of the electrical switch.

14. The method of claim 12 or 13, wherein flowing the first portion of the warm working fluid toward the electrical switch is based at least partially on a power draw of the electrical switch.

15. A method of thermal management in a datacenter, the method comprising:
flowing (648) a first portion of a cold working fluid toward a datacenter compute resource;
receiving (650) heat from the datacenter compute resource with the first portion of the cold working fluid to create a first warm working fluid;
flowing (652) the first warm working fluid away from the datacenter compute resource toward a coolant distribution unit, CDU;
flowing (654) a second portion of a cold working fluid toward an electrical switch;
receiving (656) heat from the datacenter compute resource with the second portion of the cold working fluid to create a second warm working fluid;
flowing (658) the second warm working fluid away from the electrical switch toward the CDU; and
exhausting (660) heat from the warm working fluids.
